# EUROPEAN PATENT APPLICATION

(11) **EP 2 557 605 A2**
(43) Date of publication of application: **13.02.2013**
(21) Application number: 12250122.4
(22) Date of filing: 15.06.2012
(51) Int. Cl.: H01L 31/048

(54) **Roof-mounted solar panels**

(30) Priority: 16.06.2011 GB 201110245
(71) Applicant: Makin, Stephen John, Grandby Industrial Estate Weymouth DT4 9TB (GB)
(72) Inventor: Makin, Stephen John, Grandby Industrial Estate Weymouth DT4 9TB (GB)
(74) Representative: Harkness, Katherine Joy

(57) **Abstract**

A system for installing a pre-manufactured solar panel comprising a regular array of solar cells on a substrate of defined lateral and vertical dimensions in a pitched roof having a covering of mutually similar slates or other roofing elements of defined lateral and vertical dimensions and defined profile laid in overlapping and mutually staggered courses comprises a carrier 10 is made in two sections, namely a head side 24 and a tail side 26 formed with a recess 16 that accommodates the solar panel 20 on a substrate 18. The head side 24 and the tail side 26 are crimped together at 28 by means of rivets, and the head side 24 overlays the tail side 26 with a portion 24a extending partially over the recess 16 towards (but not covering) the solar panel 20 on the substrate 18. The head side 24 is formed with a first series of depressions 30 of broadly linear form, which depressions 30 extend rearwardly of the sky face 12 to make up the thickness of the carrier 10 to approximately the same as a slate and also provide spaces between the depressions 30 through which electrical wiring (not shown) for the solar panel 20 can pass. The tail side 26 is formed with a second series of depressions 32 of broadly triangular form, which depressions 32 provide stiffening to the tail side 26 in the region overlaid by and riveted to the head side 24.

## Description

This invention concerns the mounting of a solar-activated photovoltaic unit upon a roof, particularly but not necessarily exclusively the mounting of a pre-manufactured solar panel upon a slated or tiled pitched roof of a domestic property. (A "pre-manufactured solar panel" herein means a photovoltaic (PV) solar panel previously manufactured for general application, and therefore of defined configuration, rather than a solar panel tailored to a specific site or application or specifically designed to fit a particular roof).

Currently it is usual for solar panels to overlay a conventionally tiled or slated roof, being secured thereto by bolts or other fittings, and not matched in dimensions or location to the pattern of slates or tiles. This gives rise to a number of problems: the fittings are expensive; loadings are unbalanced; the overlain position causes problematic wind effects; and installation lacks aesthetic appeal because the panel is not integrated into the slating/tiling.

Previous attempts to include a pre-manufactured solar panel within roofing, rather than overlaying it, have involved complicated and expensive fittings and have nevertheless not been properly integrated into the design of the roofing. An example is described in United States Patent Application US 2005/0005534 (Nomura). This describes a system for mounting a solar cell module on a tiled roof, within the tiles and fitted to their dimensions. However, rather than dimensioning the module to match the tiles, they are fitted to the tiles by separate members that fill spaces between the modules and the tiles. This adds complication and cost, and also disrupts the tile pattern. Further, Nomura's system is restricted to use with one particular form of tile.

The market in domestic pitched roofing (and some smaller commercial roofs) is dominated by three somewhat different roofing systems. By volume these are slate roofing, interlocking tiled roofing and plain tiled roofing. The present invention can be adapted to all three of these roofing systems.

Conventional solar cells are both rigid and fragile and produced in a limited range of sizes, and they are conventionally mounted by means of solar glass which is itself fragile and difficult to work with. Resulting installation problems require specially trained installers who necessarily charge a premium for installations, adding considerably to costs. Currently there is no simple solar panel system that can be sold off the shelf for installation by regular builders or roofers.

It is not feasible either to cut pre-manufactured solar panels to fit on site or to have solar panels specifically manufactured to fit an individual site. For good and cost-effective performance it is necessary to use widely available technology, which in practice means using solar panels comprising arrays typically of 125mm x 125mm or 156mm x 156mm solar cells mounted upon 4mm solar glass using an EVA adhesive with a tedlar backing. The use of such panels gives rise to questions concerning long-term adhesion of the panels to a given substrate and the risk of *in situ* water ingress into the panels. In addition, the panels must meet roof loading criteria and resist wind uplift without adverse effect on the weatherproofing requirements of the roof.

It is an object of the present invention to enable the various problems outlined above to be overcome and the roofing criteria to be met.

Accordingly the invention provides a system for installing a pre-manufactured solar panel comprising a regular array of solar cells on a substrate of defined lateral and vertical dimensions in a pitched roof having a covering of mutually similar roofing elements of defined lateral and vertical dimensions and defined profile laid in overlapping and mutually staggered courses, wherein said system comprises a carrier whereon the substrate is located for installation of the panel within an area of said covering extending laterally and vertically and delineated by a plurality of neighbouring roofing elements in said covering, which plurality is an integral number; said carrier comprises first engagement means engageable with said plurality of roofing elements and second engagement means engageable with the substrate; and said carrier has lateral and vertical dimensions not less than the corresponding dimensions of said area and conforms to the profile of the roofing elements delineating said area.

In essence the invention provides a bridge between the dimensions of the solar cells, which are predetermined according to a standard and in practice invariable, (or, more precisely, the dimensions of a panel incorporating a regular array of such cells), and the dimensions of the slates or tiles laid on the roof, which are also predetermined according to a standard but where the different roofs have different standards: for instance, one roof may have tiles of a particular standard form, another may have tiles of another form and a third may have slates of a completely different form. The invention provides this dimensional bridge without the complication, cost and visual disruption of additional filler pieces as in the Nomura arrangement mentioned above.

A first embodiment of the invention conforms to roofing elements which are slates of specified standard dimensions. Slates are available in many sizes but by way of example a typical slate has a lateral dimension of 250mm and a vertical dimension of 500mm and a mean thickness of about 5mm, to conform to which a carrier according to the invention would have a lateral dimension of 1520mm and a vertical dimension of 500mm and an overall thickness of 4.5mm. The carrier may be formed from aluminium sheet material and comprise a forwardly directed sky face and a rearwardly directed roof face 6mm apart and a recess extending rearwardly of said sky face wherein the substrate is located. The carrier may have a head side and a tail side, the head side being formed with a first series of depressions extending rearwardly of said sky and the tail side being formed with said recess and a second series of depressions extending rearwardly of said sky face. The head side and the tail side of the carrier may be formed in two sections joined together with the head side overlaying the tail side with a portion extending partially over said recess towards the panel on the substrate.

In an alternative version of the first embodiment of the invention, the carrier may be formed from synthetic plastics material and comprise a back sheet having a tail side whereon said substrate is located and a head side overlaid by a front sheet extending to the substrate, wherein said substrate and said front sheet are secured to said back sheet by double-sided adhesive tape and wherein a seal is provided between the substrate and the front sheet.

A second embodiment of the invention conforms to roofing elements which are interlocking tiles of specified standard dimensions each having a head formed with a return for engaging a batten of the roof thereby to locate the tile in a said course and a tail formed with a return for resting upon a tile in a course below. In this embodiment the carrier may comprise a sheet having a front face to receive the substrate incorporating the solar panel, a rear face and rearwardly directed upper and lower resilient lips, said lips being angled towards each other to grip heads and tails of the plurality of tiles with said rear face against the tiles and to accommodate variations in the vertical dimension of the tiles. Preferably the upper lip extends rearwardly from the sheet by an amount not less than the return at the head of the tiles and the lower lip extends rearwardly from the sheet by an amount not less than the return at the tail of the tiles. The carrier sheet may have a tail side whereon said substrate is located and a head side overlaid by a cover sheet extending to the substrate, wherein said substrate and said front sheet are secured to said back sheet by double-sided adhesive tape and wherein a seal is provided between the substrate and the front sheet.

A third embodiment of the invention conforms to roofing elements which are plain tiles, either flat or cambered, of specified standard dimensions 168mm wide by 268mm high and and 12mm thick. For use with such tiles, a carrier according to the invention would have a lateral dimension equal to N or (N+0.5) times the width of the tile, where N is an integer and the (N+0.5) option allows for half-width tiles in staggered courses. The carrier is preferably formed with a recess extending parallel to its lower edge as laid for the width of the carrier. The carrier may be formed with two laterally extending wings, one on each side, with one forward of the other so that the wings of adjacent carriers do not foul one another.

Thus the carrier of the invention is dimensioned both laterally (ie from side to side across the roof as laid) and vertically (up and down the roof as laid) to match the corresponding dimensions of the slates or tiles as laid, or selected multiples thereof. In this way the solar panel when laid fits in with the pattern of slates or tiles on the roof, so the roof as a whole has a harmonious appearance. At the same time, the thickness of the panel is substantially matched to the thickness of the slates or tiles as laid. In this way the panel lies substantially coplanar with the tiles as laid, rather than above them, and is therefore protected from adverse wind forces.

The invention can be embodied in different configurations to accommodate the most common roofing systems - slate roofing, interlocking tiled roofing and plain tiled roofing - in their standard forms. Thus the invention offers widespread utility and hence potential cost savings from extended usage.

The invention allows pre-manufactured solar panels to be readily and securely mounted to almost any domestic or small commercial roof. It allows for the good and cost-effective performance whilst integrating the panel into the roof system. By means of the invention, the solar panel is effectively part of the roof covering, rather than being bolted to the outside with all of the problems that this creates. And the installation can be carried out by regular builders or roofers, without the cost penalty of specialist workers or special tools.

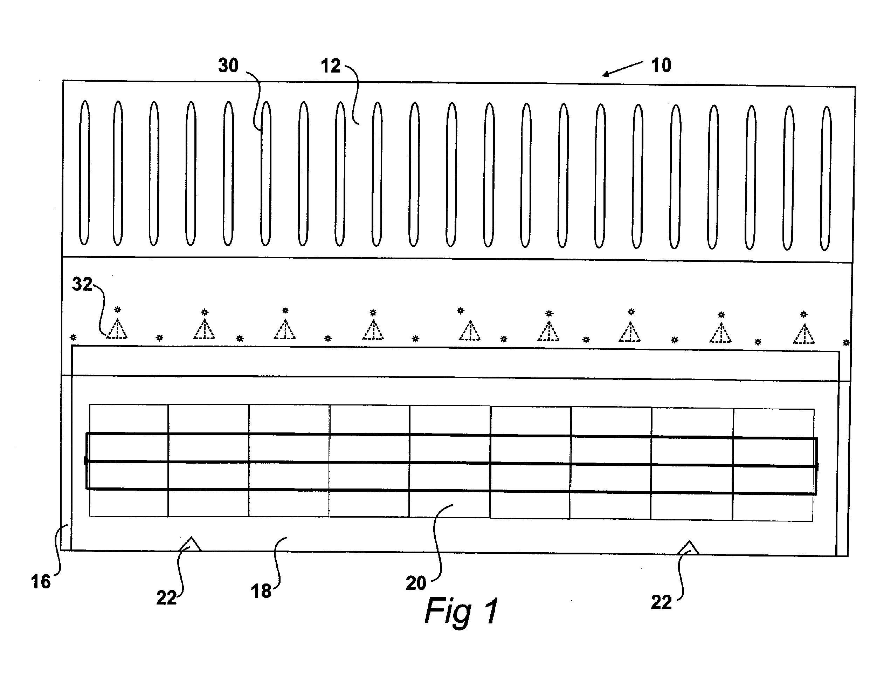

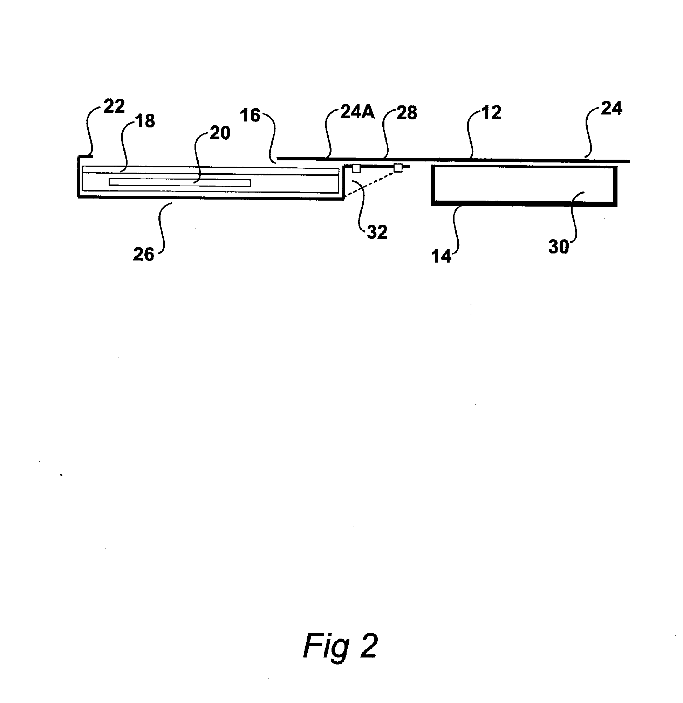

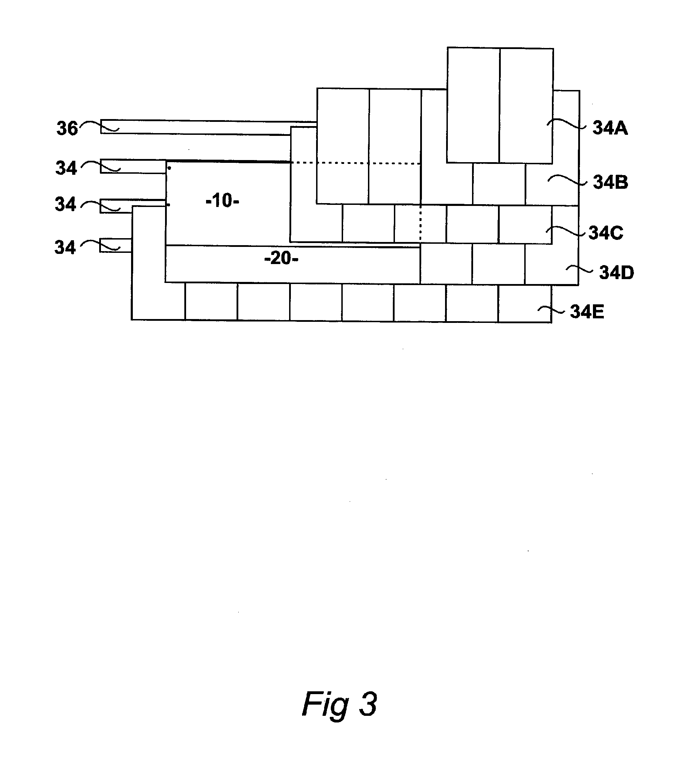

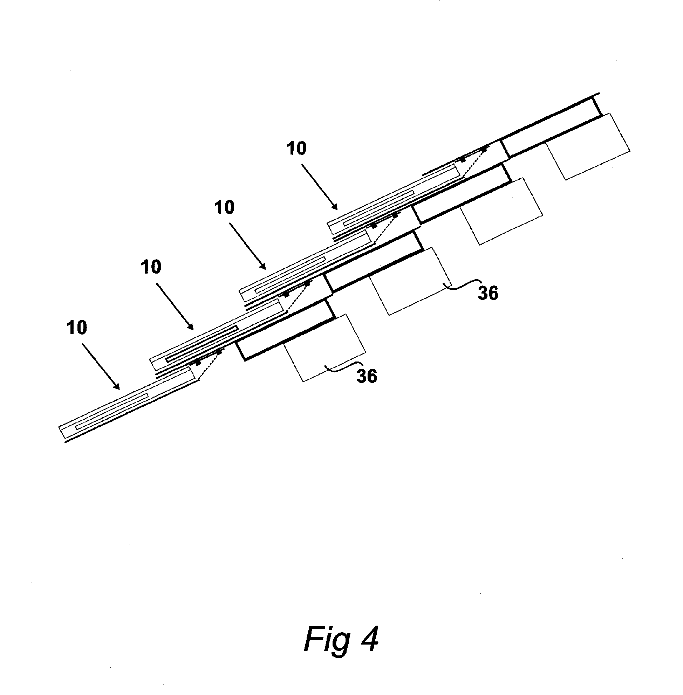

Further features of the invention will be apparent from the following description with reference to the accompanying drawings, which are purely schematic and in which -
Figures 1 to 4 illustrate a first embodiment of the invention, herein called the "easy solar slate", for use with roofing slates, Figure 1 showing the easy solar slate in plan view, Figure 2 showing the easy solar slate in profile, Figure 3 showing a roof installation in plan view and Figure 4 showing in side elevation an installation of a plurality of easy solar slates;

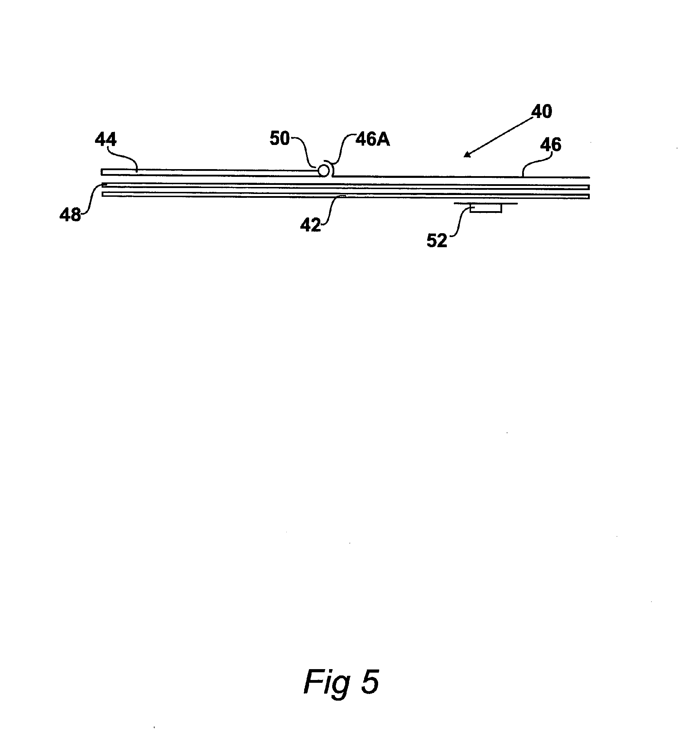

Figure 5 illustrates in side elevation a variant of the easy solar slate;

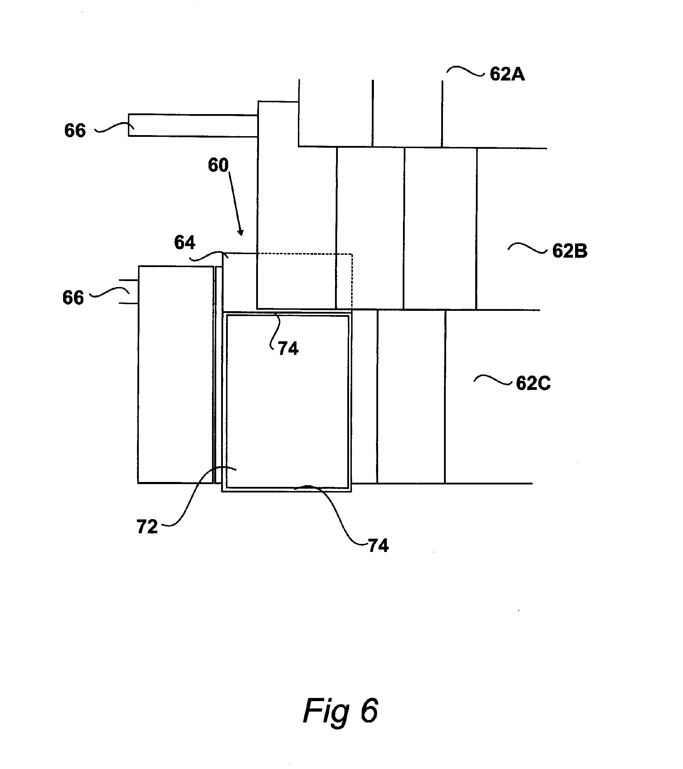

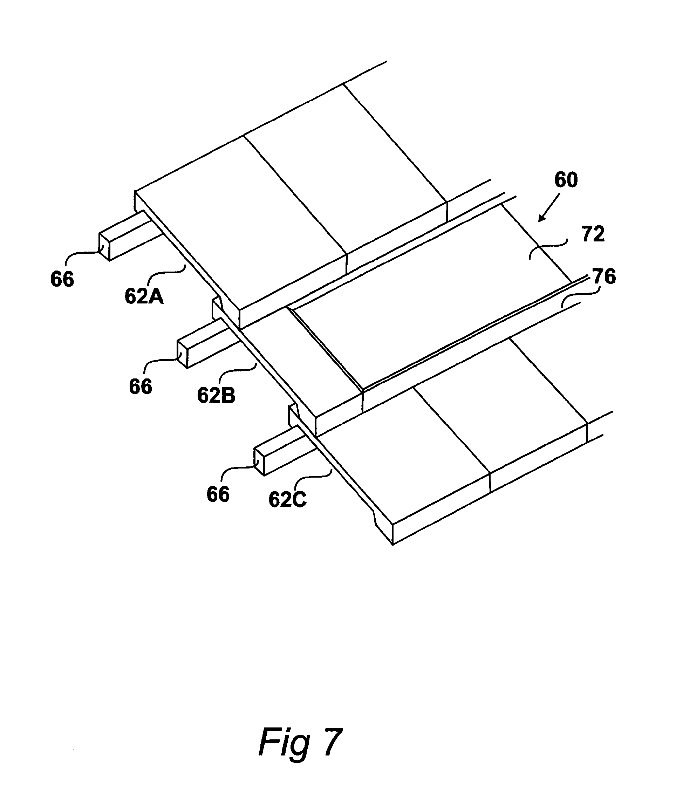

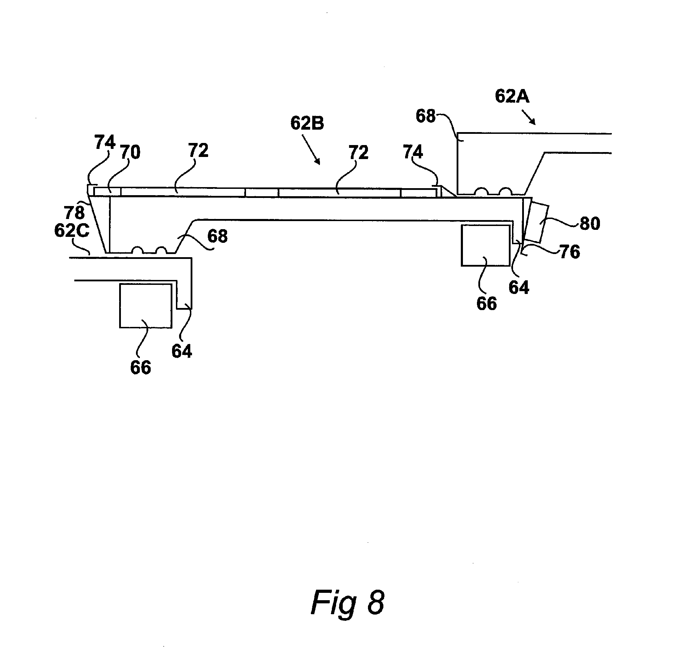

Figures 6 to 8 illustrate a second embodiment of the invention, herein called the "easy solar tile", for use with interlocking roofing tiles, Figure 6 showing an installation of easy solar tiles in plan view, Figure 7 being an isometric view corresponding to Figure 5 and Figure 8 showing the easy solar tile in profile; and

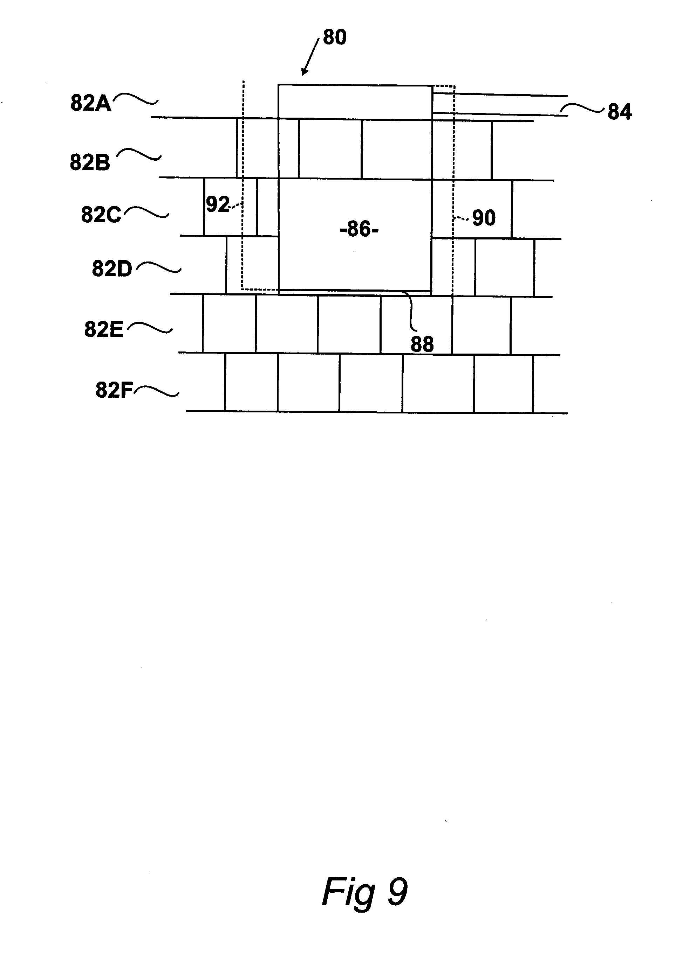

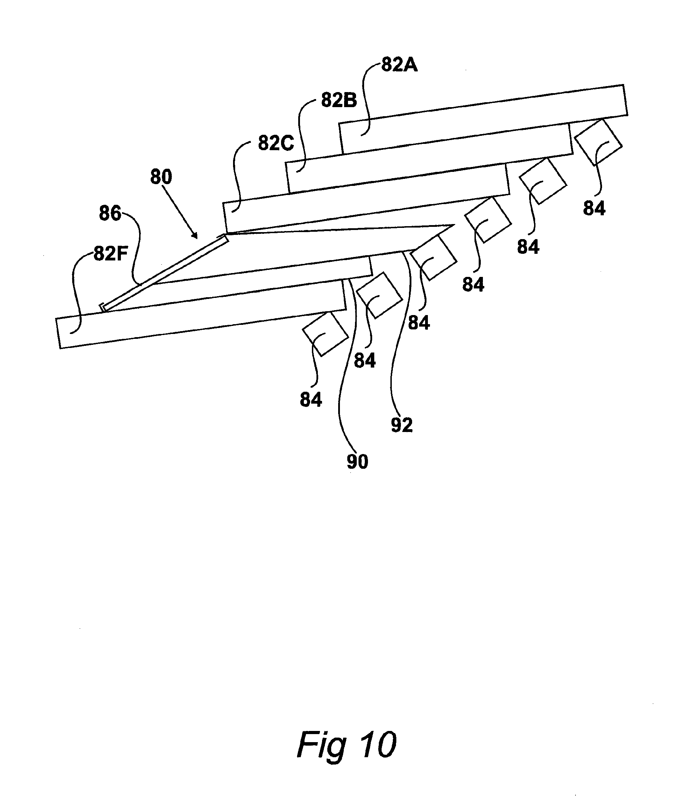

Figures 9 to 10 illustrate a third embodiment of the invention, herein called the "easy solar plain tile", for use with plain roofing tiles, Figure 9 showing an installation of easy solar plain tiles in plan view and Figure 10 being a side elevation of an installation showing an easy solar plain tile in profile.

### Easy solar slate

To place the easy solar slate into context its description will be preceded by a brief explanation of slate roofing and the needs that the present invention must meet.

In UK, more than 95% of the slate roofing market uses two different sizes of slate those, namely 250mm x 500mm and 300mm x 600mm. (Other countries have different standards, and in much of Europe many tiles are 220mm x 320mm). The slates are installed side by side in overlapping courses that are staggered to produced what is known as a broken bond. The slates are double-lapped in so far as each course overlaps the next by more half the vertical dimension of the slate, the lap being variable but usually about 100mm. This means that a slate of vertical dimension 500mm will show 200mm of that, although the full width of 250mm is shown. In other words the exposed area of the slate when laid, known as the margin, is 250mm x 200mm. Typically a slate of 600mm vertical dimension will show an area of 300mm x 250mm.

If anything such as a solar panel installation is mounted upon these slates (such as a hitherto conventional form of solar panel installation, this increases the thickness and adds to the weight. Conventionally, solar panels have to be mounted at a point where an adjoining slate ends, and this creates a step of about 5mm (being the thickness of the slate). If the panel were mounted on the slate then water would sit behind the panel and affect the adhesion and stability of the system. And because a standard solar cell is 156 x 156mm, and even the largest area is 300mm x 250mm, an individual slate can accommodate only one cell, and it is neither effective nor efficient to apply one cell per slate.

Because the panels are formed of glass they are difficult to fix in place (especially where subject to wind loading) and in practice it is not possible (at least economically) to depart from standard size panels, the solar panels themselves cannot be used as direct substitutes for slates.

Considering the commonest standard sizes of slates, the lowest common multiple of the 250mm and 300mm lateral dimensions is 1500mm. Thus a solar panel slightly wider than 1500mm (say 1520mm) to allow for small gaps between adjacent tiles will accommodate nine 156mm solar cells side by side, and therefore can be included in very many slated roofs effectively and efficiently. Those skilled in the art will appreciate that the invention can be adapted to accommodate 125mm solar cells.

Referring now to Figures 1 and 2 the easy solar slate indicated generally at 10 is formed from aluminium sheet material and comprises an upwardly directed sky face 12 and a downwardly directed roof face 14 spaced apart to provide an overall thickness of 6mm. A recess 16 extends rearwardly of the sky face 12, and a solar panel comprising a substrate 18 carrying an array 20 of solar cells is located in the recess 16 and held therein by tabs 22. Overall, the carrier 10 has a lateral dimension of 1520mm and a vertical dimension of 500mm.

As can be seen from Figure 2, the carrier 10 is made in two sections, namely a head side 24 and a tail side 26, the tail side 26 being of generally Z-shaped form to provide the recess 16. The head side 24 and the tail side 26 are crimped together at 28 by means of rivets, and the head side 24 overlays the tail side 26 with a portion 24A extending partially over the recess 16 towards (but not covering) the solar cells 20 on the substrate 18. The head side 24 is formed with a first series of depressions 30 of broadly linear form, which depressions 30 extend rearwardly of the sky face 12 to make up the thickness of the carrier 10 to approximate that of the slates and also to provide spaces between the depressions 30 through which electrical wiring (not shown) for the solar panel 18/20 can pass. The tail side 26 is formed with a second series of depressions 32 of broadly triangular form, which depressions 32 provide stiffening to the tail side 26 in the region overlaid by and riveted to the head side 24.

Figure 3 illustrates a roof and shows in plan view five courses of 500mm x 250mm slates 34A to 34E laid upon battens 36. The roof incorporates an easy solar slate whereof the carrier 10 is secured to the battens, overlaid by the second and third courses 34B and 34C and overlaying the fourth course 32D, and a plurality of slates in the fourth course 34D is omitted to provide an open area for the solar panel 18/20. The slates being each 250mm wide, the omission of six in the fourth course 34A provides for a solar panel with nine cells 20 side by side; and those skilled in the art will understand that the omission of five slates in a roof covering of slates 600mm wide would accommodate a similar panel. It should also be noted that the carrier 10 is configured and arranged to engage slates bordering the area of the solar panel 20 to form a weatherproof seal therewith and to position the solar panel in said area with at least lateral symmetry.

Figure 4 shows how carriers 10 embodying the invention can be laid upon battens 36 of a roof. In this respect the carriers 10 are laid like the slates of the roof, save that each carrier 10 has a lateral extent greater than that of a plurality of slates. Thus in use the solar panel comprising the solar cells 20 on the substrate 18 lies within an area delineated by a plurality of neighbouring slates which are omitted from the roof. (Those skilled in the art will perceive that the carrier 10 as described, having a lateral dimension of just over 1500mm, can replace a row of five 300mm slates or six 250mm slates, these being common sizes). Further, because each carrier 10 has a profile similar to that of the slates, inasmuch as its cross-section as illustrated by Figures 2 and 4 has an "envelope" approximately the same as that of the slates, it follows that the installed assembly lies within the roof covering formed by the slates. Therefore the installation is satisfying both aesthetically - because it does not protrude above the plane of the roof covering - and functionally - because it is sheltered from wind which might otherwise lift it from the roof. The aesthetic appearance can be further enhanced by colouring the carrier 10, for instance by anodising the aluminium, to match the colour of the slates.

An alternative form of the easy solar slate is illustrated by Figure 5. In this alternative version the carrier 40 is formed from glass reinforced plastics material (GRP) and comprises a back sheet 42 having a tail side whereon a solar panel 44 is located and a head side overlaid by a front sheet 46 extending to the solar panel 44. Although not detailed in Figure 4, for simplicity of illustration, the solar panel 44 comprises an array of solar cells mounted on a substrate, and this substrate is secured to the back sheet 42 by double-sided adhesive tape 48. The double-sided adhesive tape 48 also joins the back sheet 42 and the front sheet 46 together. The front sheet 46 has at its lower edge a lip 46a over the solar panel 44 and the joint between these is sealed by tape 50. A junction box 52 for the electrical wiring (not shown) of the solar panel 44 is secured to the roof face of the back sheet 42; and to avoid fouling battens or other parts of the roof the junction box 52 extends no more than 25mm rearwardly of the back sheet 42 and is located in a region between 120mm and 230mm from the top edge of the backing sheet 42.

### Easy solar tile

To place the easy solar tile into context its description will be preceded by a brief explanation of interlocking tile roofing and the needs that the present invention must meet.

A large part of the interlocking tile roofing market is taken by flat interlocking tiles. These tiles are a high performance product, they are heavy against wind uplift and the water resistance provided by the interlock allows a lower pitch for the roof. The maximum exposed surface area (margin) of these tiles is about 290mm wide x 320mm high and therefore only 1 cell could be mounted per tile. Roof loading, water ingress and adhesion problems will be well understood from the foregoing description with relation to slates, and interlocking tiles also present particular problems in providing for electrical wiring.

Interlocking tiles have a substantially flat sky face but a rearwardly directed return at both head and tail makes each tile about 30mm thick.

The easy solar tile may be a preformed injection-moulded semi-rigid recycled PVC product or an anodised aluminium pressing, and it may be of any appropriate colour to match a particular roof. The easy solar tile is formed from sheet material approximately 1 mm thick and has an overall profile 36mm deep designed to fit over a plurality of tiles in a course, having a vertical dimension of 430mm. The tile can be can be 344mm (4 cells), 500mm (6 cells), 658mm (8cells) or 816mm (10 cells) wide, or multiples of those dimensions.

The lower edge of the solar easy tile has a 10mm return that slides under the tiles below it and the front edge is angled outward from the tile in order to extend the tile area to accommodate a 330mm solar panel that is 2 cells high, so as to make optimum use of the area available. The upper edge of the easy solar tile is angled back to accommodate the slight variations in the length of the tiles and there is a clip that holds it in place. A locating tab extends along the width of both the upper (head) and lower (tail) edges. The easy solar tile can fitted to a new roof, or to an existing roof by temporary removal of an upper course of tiles for access.

Referring now to Figures 6 to 8 these show a carrier 60 installed in a roof having a covering of interlocking tiles 62 of specified standard dimensions. The tiles are laid in overlapping and staggered courses of which three courses 62A, 62B and 62C are shown in Figures 6 to 8. As can be seen from Figure 8 each of the tiles has a head formed with a return 64 for engaging a batten 66 of the roof thereby to locate the tile 62 in a said course and a tail formed with a return 68 for resting upon a tile 62 in a course below. And as can be seen from Figures 6 and 7 the lateral dimension of the carrier 60 is greater than that of a plurality of the tiles 62, which plurality the carrier 60 overlies.

The carrier 60 comprises a sheet having a front face 64 to receive a solar panel comprising a substrate 70 bearing an array 72 of solar cells (two of which are shown in Figure 8). The substrate 70 is held in place by tabs 74 at top and bottom, although it may otherwise or as well be secured by other means such as adhesive tape.

The carrier 60 is formed with rearwardly directed upper and lower resilient lips 76 and 78 respectively, the lips 76 and 78 being angled towards each other to grip heads and tails of the plurality of overlaid tiles 62 with the rear face of the carrier against the tiles 62. Those skilled in the art will appreciate that, even with specified standard dimensions, tiles vary somewhat (especially when supplied by different manufacturers) and the lips 76 and 78 are therefore configured and arranged to accommodate variations (within acceptable tolerances) in the vertical dimension of the tiles. It will also be noted from Figure 8 that the upper lip 76 extends rearwardly from the sheet by an amount not less than the return 64 at the head of the tiles 62 and the lower lip 78 extends rearwardly from the sheet by an amount not less than the return 68 at the tail of the tiles.

A junction box 80 for connecting electrical wiring (not shown) to the solar panel 72, which junction box 80 is attached to the upper lip 74 of the carrier 60.

Rather like the carrier 40 described above with reference to Figure 5, the carrier 60 may be formed from a back sheet having a tail side whereon the substrate 70 is located and a head side overlaid by a cover sheet extending to the substrate 70, the substrate 70 and the cover sheet being each secured to the back sheet by double-sided adhesive tape and a seal being provided between the substrate 70 and the front sheet. It is considered that those skilled in the art will be well able to envisage this arrangement without a detailed illustration.

### Easy solar plain tile

To place the easy solar plain tile into context its description will be preceded by a brief explanation of plain tile roofing and the needs that the present invention must meet.

Plain tiles can be either flat or cambered with a slight curve in lateral and/or vertical directions. They are laid next to each other in uniform rows with a broken bond and double lapped. The exposed area of each plain tile is about 100mm x 160mm, which does not allow for solar cells to be applied effectively or efficiently to individual tiles.

The easy solar plain tile is designed to replace two rows of plain tiles, with an exposed area of 200mm vertical dimension. When a row of neighbouring tiles is removed there are two opposite steps that appear at the ends of the row, because of the broken bond, and the easy solar plain is configured and arranged to make up for this.

The easy solar plain tile is a preformed injection-moulded semi-rigid recycled PVC product or an anodised aluminium pressing and it can be any colour. The easy solar plain tile file is 12mm deep at the front edge to match the front edge of the plain tiles and otherwise its form conforms generally to the profile inasmuch as it has an "envelope" close to the profile of the tile. Thus the easy solar plain tile follows the line of the length of a first tile to the appropriate batten and then extends up reach the batten above and support a third row of tiles to be placed above it.

On the roof face the easy solar plain tile is straight from the underside of the front edge and back to the top edge. By this means the easy solar plain tile is 12mm thick at both head and tail top and 25mm thick in the middle, which thus accommodates both flat and cambered plain tiles. Overall the easy solar plain tile has a vertical dimension of approximately 365mm and a lateral dimension N or (N+0.5) times the width of the tiles, where N is an integer.

The easy solar plain tile is designed to fit within a double course of tiles. There is a recess on the exposed sky face that starts 10mm up from the tail edge and runs for the whole width to accommodate the solar panel, this recess being approximately 200mm high and 4.5mm deep. Locating clips or tabs 4mm high extend along the width of the lower edge and the top. The upper tab will direct water running off the roof over the panel and prevent an accumulation of water.

Two side wings protrude out 84mm on either side and beyond the widths of the carrier sizes stated. These wings start 20mm down from the top edge and extend down either side and are recessed and predrilled to allow for the easy solar slate to be screwed to battens of the roof. The wings are 1 mm thick and act as a soaker so that the abutting tiles from the second course can neatly connect to sides by using a tile and a half. These wings allow the easy solar plain tile to be neatly fitted into the course of the plain tiles and maintain an aesthetic appearance.

The easy solar plain tile can be fitted to a new roof, or to an existing roof by removing an upper course of tiles temporarily to facilitate access.

Referring now to Figures 9 and 10 these show a carrier 80 installed in a roof having a covering of plain tiles 82 of specified standard dimensions laid on battens 84. The tiles 82 are laid in overlapping and staggered courses of which six courses 82A to 82F can be seen in Figure 9. As shown in Figure 9 the carrier 80 has both lateral and vertical dimensions greater than the corresponding dimensions of each tile 82. Thus (see Figure 9) the carrier 80 is somewhat wider than a plurality of tiles 82: broadly, its width is not lees than N or (N+0.5) times the width of a tile, where N is an integer. Also (see Figure 10) the profile of the carrier 80 effectively bridges two courses of flat tiles, 82D and 82E. Those skilled in the art will appreciate that the carrier 80 will also conform to the profile of cambered tiles, but it is not considered necessary to detail this in the accompanying drawings.

A solar panel 86 is secured to the front face (sky-facing) of the carrier 80 in a recess 88 extending parallel to its lower (tail) edge as laid for the width of the carrier 80.

In addition, as shown in Figure 10, the carrier 80 is formed with two laterally extending wings 90 and 92 respectively, one on each side. The wing 90 is outwardly disposed relative to the wing 92 so that carriers 80 can be laid side by side without the wings fouling one another.

Those skilled in the art will now appreciate that the invention provides a means of installing a pre-manufactured solar panel comprising a regular array of solar cells on a substrate of defined lateral and vertical dimensions in a pitched roof having a covering of mutually similar roofing elements of defined lateral and vertical dimensions and defined profile laid in overlapping and mutually staggered courses, whether the roofing elements be slates or interlocking tiles or plain tiles. It should be understood that various modifications may be made to the embodiments of the invention described above without departing from the scope of the invention as defined in the claims hereunder.

It should also be understood that -
(a) A carrier of the invention may be formed of anodised aluminium or GRP or by injection moulding of synthetic plastics material;
(b) A solar panel may be attached to the carrier with tape, which may serve as an insulator and/or a cushion as well as an adhesive, or by tabs, clips or other means;
(c) The solar panel may be removal from an in-situ carrier, for maintenance or replacement eg for performance upgrade;
(d) In all cases a performance indicator such as a visible LED display may be provided to show any degradation or failure of panels.

## Claims

1. A system for installing a pre-manufactured solar panel comprising a regular array of solar cells on a substrate of defined lateral and vertical dimensions in a pitched roof having a covering of mutually similar roofing elements of defined lateral and vertical dimensions and defined profile laid in overlapping and mutually staggered courses, wherein:
said system comprises a carrier whereon the substrate is located for installation of the panel within an area of said covering extending laterally and vertically and delineated by a plurality of neighbouring roofing elements in said covering, which plurality is an integral number;
said carrier comprises first engagement means engageable with said plurality of roofing elements and second engagement means engageable with the substrate; and
said carrier has lateral and vertical dimensions not less than the corresponding dimensions of said area and conforms to the profile of the roofing elements delineating said area.

2. A system for installing a pre-manufactured solar panel as claimed in claim 1 wherein said carrier has a lateral dimension not less than N or (N+0.5) times the lateral dimension of a said roofing element.

3. A system for installing a pre-manufactured solar panel as claimed in claim 1 or claim 2 wherein said carrier is configured and arranged to engage roofing elements bordering said area to form a weatherproof seal therewith and to position the solar panel in said area with at least lateral symmetry.

4. A system for installing a pre-manufactured solar panel as claimed in any of claims 1 to 3 in a roof wherein said roofing elements are slates of specified standard dimensions.

5. A system for installing a pre-manufactured solar panel as claimed in claim 4 wherein said carrier is formed from aluminium sheet material and comprises a forwardly directed sky face and a rearwardly directed roof face up to 6mm apart and a recess extending rearwardly of said sky face, wherein the substrate is located.

6. A system for installing a pre-manufactured solar panel as claimed in claim 5 wherein the carrier has a head side and a tail side, the head side being formed with a first series of depressions extending rearwardly of said sky and the tail side being formed with said recess and a second series of depressions extending rearwardly of said sky face.

7. A system for installing a pre-manufactured solar panel as claimed in claim 6 wherein spaces between the depressions accommodate electrical wiring for the solar panel.

8. A system for installing a pre-manufactured solar panel as claimed in any of claims 4 to 7 including a junction box for connecting electrical wiring to the solar panel, which junction box is attached to the roof face of the carrier between and clear of fixing points for securing the carrier to battens of the roof.

9. A system for installing a pre-manufactured solar panel as claimed in claim 6 wherein the head side and the tail side are formed in two sections joined together with the head side overlaying the tail side with a portion extending partially over said recess towards the panel on the substrate.

10. A system for installing a pre-manufactured solar panel as claimed in claim 3 or claim 4 wherein said carrier is formed from synthetic plastics material and comprises a back sheet having a tail side whereon said substrate is located and a head side overlaid by a front sheet extending to the substrate, wherein said substrate and said front sheet are secured to said back sheet by double-sided adhesive tape and wherein a seal is provided between the substrate and the front sheet.

11. A system for installing a pre-manufactured solar panel as claimed in any of claims 1 to 3 in a roof wherein said roofing elements are interlocking tiles of specified standard dimensions each having a head formed with a return for engaging a batten of the roof thereby to locate the tile in a said course and a tail formed with a return for resting upon a tile in a course below.

12. A system for installing a pre-manufactured solar panel as claimed in claim 11 wherein said carrier comprises a sheet having a front face to receive said substrate, a rear face and rearwardly directed upper and lower resilient lips, said lips being angled towards each other to grip heads and tails of the plurality of tiles with said rear face against the tiles and to accommodate variations in the vertical dimension of the tiles.

13. A system for installing a pre-manufactured solar panel as claimed in claim 12 wherein the upper lip extends rearwardly from the sheet by an amount not less than the return at the head of the tiles and the lower lip extends rearwardly from the sheet by an amount not less than the return at the tail of the tiles.

14. A system for installing a pre-manufactured solar panel as claimed in claim 12 or claim 13 including a junction box for connecting electrical wiring to the solar panel, which junction box is attached to the upper lip of the carrier.

15. A system for installing a pre-manufactured solar panel as claimed in any of claims 11 to 14 wherein said sheet has a tail side whereon said substrate is located and a head side overlaid by a cover sheet extending to the substrate, wherein said substrate and said front sheet are secured to said back sheet by double-sided adhesive tape and wherein a seal is provided between the substrate and the front sheet.

16. A system for installing a pre-manufactured solar panel as claimed in any of claims 1 to 3 in a roof wherein said roofing elements are plain tiles of specified standard dimensions.

17. A system for installing a pre-manufactured solar panel as claimed in claim 15 for use in a roof of plain tiles **characterised in that** the carrier conforms to the profile of both flat and cambered plain tiles.

18. A system for installing a pre-manufactured solar panel as claimed in claim 16 or claim 17 wherein the carrier is formed with a recess extending parallel to its lower edge as laid for the width of the carrier.

19. A system for installing a pre-manufactured solar panel as claimed in any of claims 16 to 18 wherein the carrier is formed with two laterally extending wings, one on each side, with one forward of the other so that the wings of adjacent carriers do not foul one another.

20. A system for installing a pre-manufactured solar panel as claimed in any preceding claim wherein the system includes a visible indicator of performance of the solar panel and/or individual cells thereof.
